Europäisches Patentamt

European Patent Office

Office européen des brevets

(19)

(11) EP 0 541 455 B1

(12) FASCICULE DE BREVET EUROPEEN

(45) Date de publication et mention
de la délivrance du brevet:
**03.09.1997 Bulletin 1997/36**

(51) Int Cl.⁶: **G01R 27/26**, G01R 27/02,
H03M 1/82, G01L 9/12,
G01R 19/10

(21) Numéro de dépôt: **92420367.2**

(22) Date de dépôt: **21.10.1992**

(54) **Méthode de conversion de rapports d'impédances applicables notamment aux transmetteurs de pression industriels**

Verfahren zur Wandlung von Impedanzverhältnissen, anwendbar insbesondere für industrielle Druckgeber

Method of converting impedance ratios applicable particularly for industrial pressure transmitters

(84) Etats contractants désignés:
**DE FR GB IT NL**

(30) Priorité: **21.10.1991 FR 9113160**

(43) Date de publication de la demande:
**12.05.1993 Bulletin 1993/19**

(73) Titulaire: **Fischer & Porter GmbH
D-37079 Göttingen (DE)**

(72) Inventeur: **Neel, Christian
F-63110 Beaumont (FR)**

(74) Mandataire: **Liska, Horst, Dr.-Ing. et al
Patentanwälte
H. Weickmann, Dr. K.Fincke
F.A.Weickmann, B.Huber
Dr. H.Liska, Dr. J.Prechtel, Dr. B.Böhm, Dr.
W.Weiss, Dr. M.Herzog
Postfach 860 820
81635 München (DE)**

(56) Documents cités:
**EP-A- 0 121 841          EP-A- 0 159 786
EP-A- 0 421 395          WO-A-87/06711
WO-A-91/09278          FR-A- 2 316 798
GB-A- 2 177 806**

- **JOURNAL OF PHYSICS E/SCIENTIFIC INSTRUMENTS vol. 21, no. 3, mars 1988, pages 242-250, Ishing, Bristol, GB; S.M. HUANG et al.: "Electronic transducers for industrial measurement of low value capacitances"**
- **PATENT ABSTRACTS OF JAPAN vol. 10, no. 32 (E-379)(2089), 7 février 1986; & JP - A - 60190029**
- **PATENT ABSTRACTS OF JAPAN vol. 13, no. 268 (E-775)(3616), 20 juin 1989; & JP - A - 1058125 (MATSUSHITA ELECTRIC) 06.03.1989**

## Description

La présente invention est du domaine de l'électronique, et elle a pour objets des méthodes de mesure et leurs moyens de mise en oeuvre, notamment un convertisseur de rapports d'impédances à sortie numérique ou analogique, tel que p. ex. connu du document EP-A-0 421 395, ainsi que leurs applications dans un transmetteur de pression industriel.

On fait référence, pour connaître un transmetteur, ou capteur, de pression industriel, à un brevet FR-A-2.614.986 de la Demanderesse qui décrit une cellule de mesure de pression du type à couplage hydraulique de deux demi-cellules comportant chacune un couple d'électrodes capacitives ; l'invention s'appliquerait cependant tout aussi bien à une cellule à couplage mécanique ou encore à toute cellule de mesure procédant des variations concomitantes de deux impédances.

De façon classique la mesure des impédances est réalisée au moyen de montages, bien connus, en "ponts" ; un inconvénient majeur de ces montages réside dans l'incidence sur les mesures, de capacités parasites inhérentes à leurs circuits, et difficiles à éliminer ; en outre, ces montages exigent des courants alternatifs de forme aussi pure que possible c'est-à-dire exempts d'harmoniques gênants.

La présente invention a ainsi pour buts, de proposer des moyens, méthodes et dispositifs, visant à optimiser la fiabilité et la précision des cellules de mesures, notamment les cellules capacitives de mesure des pressions travaillant en milieux industriels hostiles, d'en permettre un contrôle plus précis et plus automatisé et, à performances égales, d'abaisser le coût des équipements.

L'invention a pour objet une méthode de mesure du rapport de deux impédances $Z1, Z2$ particulièrement capacités $C1, C2$ mais aussi résistances et inductances, de même nature, les deux impédances étant comprises dans une cellule de mesure reliée à un appareil de mesure, caractérisée de la manière la plus générale en ce qu'elle comprend la succession des étapes consistant à

- générer des signaux carrés Vh au moyen d'une horloge, de période T bien constante,
- appliquer pendant la première demi-période d'horloge, une tension Vr à l'entrée de l'impédance $Z1$, et une tension nulle V0 à l'entrée de l'impédance $Z2$, puis
- appliquer pendant la seconde demi-période d'horloge une tension Vm à l'entrée de chacune des deux impédances $Z1, Z2$,

    d'où il résulte que les entrées desdites impédances $Z1$, $Z2$ sont portées à des tensions périodiques respectivement de valeurs V1(t) pour $Z1$ et V2(t) pour $Z2$,
- appliquer, les impédances $Z1$, $Z2$ ayant leurs sorties reliées à une ligne de sortie d'impédance, le signal de ladite ligne à l'entrée inverseuse d'un amplificateur opérationnel monté en sommateur rebouclé sur une impédance Zm de même nature que $Z1$ et $Z2$,

    d'où il résulte que la sortie de l'amplificateur opérationnel est portée à une tension périodique V(t), de période T égale à celle de l'horloge, discontinue à deux seuils dont la différence E, dite signal d'erreur, ne dépend que de Vr et de Vm et est proportionnelle à $(Vr.Z1/(Z1+Z2))Vm$, enfin
- appliquer la sortie V2(t) de l'amplificateur opérationnel à l'entrée d'un détecteur synchrone commandé par l'horloge, en vue d'extraire le signal E.

Suivant une première variante de réalisation, une étape ultérieure consiste à appliquer la sortie E du détecteur synchrone à l'entrée d'un intégrateur analogique dont la sortie fournit la tension Vm qui sert à la mesure et qui est utilisée pour générer V1(t) et V2(t) à la seconde entrée des impédances,

    d'où il résulte que, le couplage des entrées et sorties des tensions étant ainsi réalisé, la tension Vm générée par la boucle formée par les éléments précédents converge vers un état d'équilibre et fournit de ce fait une valeur au rapport $Z1/(Z1+Z2)$ dépendant uniquement des tensions Vr et V0, à l'exclusion de toute autre grandeur électrique du circuit.

Suivant une deuxième variante de la méthode, une étape ultérieure consiste à appliquer la sortie du détecteur synchrone à l'entrée d'un convertisseur analogique/numérique de type intégrateur au sens mathématique, dont la sortie constitue la représentation numérique de la sortie du détecteur synchrone, utilisable pour un traitement de données (calcul de Vm/Vr et $Z1/(Z1+Z2)$), puis à convertir avec un convertisseur numérique-analogique cette représentation numérique en la tension Vm qui est appliquée à la seconde entrée des impédances.

Suivant une troisième variante pouvant être considérée comme une application de la précédante, une méthode relevant de l'invention comprend les étapes suivantes consistant à :

- appliquer la sortie du détecteur synchrone à l'entrée d'un oscillateur dont la fréquence est commandée par, et proportionnellement à lui, le signal B issu du détecteur synchrone,
- appliquer la sortie de l'oscillateur à l'entrée d'un compteur-décompteur binaire à sorties parallèles constituant un mot binaire M, et à convertir ce mot binaire M à sa représentation analogique constituant la tension Vm.

De préférance ce mot binaire M est un mot de seize bits d'une valeur $M=256N+n$, N représentant le byte le plus significatif et n représentant le byte le moins significatif.

L'étape de convertir le mot binaire M à la tension Vm consiste:

- à générer, au moyen d'un premier convertisseur numérique-rapport cyclique recevant les connexions pour le byte N le plus significatif, un signal en tension, rectangulaire, de période T', dont le rapport cyclique vaut N/256 et dont les deux paliers, haut et bas, sont respectivement:

    - une tension positive stable Vr,
    - la tension nulle, puis

    - à générer, au moyen d'un second convertisseur numérique-rapport cyclique recevant les connexions pour le byte n le moins significatif, un second signal rectangulaire, de période T', dont le rapport cyclique, de caractéristiques d'amplitude identiques à celles du premier signal, vaut n/256,
    - à filtrer ledit second signal rectangulaire afin d'en extraire sa valeur moyenne Vx=Vr.n/256,
    - à appliquer ledit premier signal rectangulaire à la première entrée d'un commutateur analogique, et la tension continue Vx à la seconde entrée dudit commutateur, ledit commutateur étant alternativement "passant" entre l'une ou l'autre de ses entrées et sa sortie,
    - à appliquer un signal de commande, de période T' audit commutateur analogique, de telle sorte que ledit commutateur analogique

        . soit passant entre sa seconde entrée et sa sortie pendant une durée t'=T'/256 lors du passage dudit premier signal, de son palier haut vers son palier bas, et
        . soit passant entre sa première entrée et sa sortie pendant la durée complémentaire (T'- t') de la période T',

        d'où il résulte l'apparition d'une tension variable en fonction du temps Vs(t) à la sortie du commutateur, puis enfin :
    - à filtrer la tension Vs(t) en vue d'en extraire sa valeur moyenne Vm =Vr.(256N+n)/65536 qui constitue la sortie analogique ; de préférence les opérations de filtration sont réalisées au moyen de filtres passe-bas.

Les avantages de cette méthode de conversion digitale-analogique (ci-dessous appelée "méthode de conversion numérique-analogique par Convertisseur Numérique-Analogique à Rapport Cyclique Fractionné" (CNARCF)), par rapport aux méthode existantes sont les suivants:

a) simplification, pour une qualité donnée de réponse, du filtre passe-bas généralement utilisé dans les conversion A/N, avec une incidence favorable sur le coût, et
b) minimisation de l'influence de la tension soumise à mesure, sur des oscillations résiduelles après filtrage.

La présente invention sera mieux comprise, et des détails en relevant apparaîtront, à la description qui va en être faite à travers des moyens de mise en oeuvre des méthodes susdéfinies, et en relation avec les figures des planches annexées, dans lesquelles

- la fig.1 représente un circuit électronique illustratif de la généralité de la méthode de mesure de rapports d'impédances, dans une application simplifiée,
- la fig.2 est constituée d'un schéma d'un ensemble de commutation et de diagrammes des tensions aux bornes de l'ensemble de commutation,
- - la fig.3 est un organigramme fonctionnel des moyens mis en oeuvre dans la première variante de la méthode,
- la fig.4 est un organigramme fonctionnel des moyens mis en oeuvre dans la deuxième variante de la méthode,
- la fig.5 est un organigramme fonctionnel des moyens mis en oeuvre dans la conversion numérique-analogique par Convertisseur Numérique-Analogique à Rapport Cyclique Fractionné" (CNARCF),
- la fig.6 montre un couple de diagrammes illustratifs d'une étape de la méthode de la figure précédente, et
- la fig.7 est un schéma synoptique d'un circuit, illustrant une autre variante de la méthode de l'invention mettant en oeuvre à la fois un CNARCF de la fig.5 et une matrice de commutation.

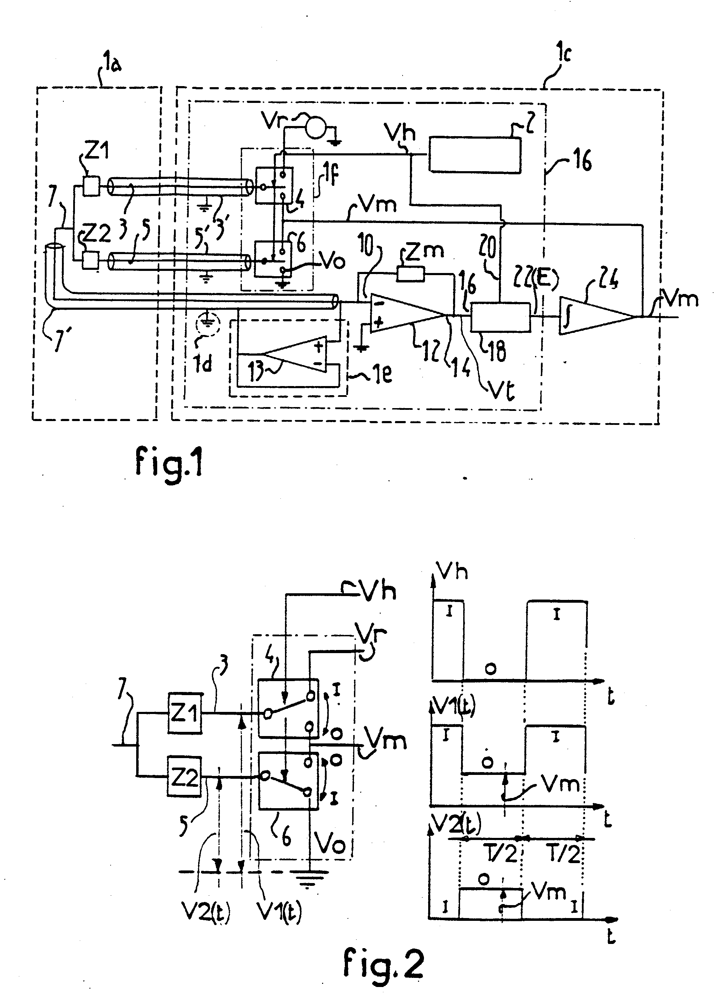

Sur la fig.1, un disposif de mesure du rapport de deux impédances Z1 et Z2, dit aussi convertisseur de rapport d'impédances, est réparti sur deux blocs principaux 1a et 1c, le bloc la désignant une cellule de mesure, telle par exemple que cellule capacitive de mesure de pressions, tandis que le bloc 1c désigne la partie fonctionnelle de l'appareil de mesure sans les organes de lecture ou d'enregistrement des mesures.

L'ensemble du convertisseur est contrôlé par un signal logique Vh généré par une horloge 2 à basse fréquence, de l'ordre de 500 Hz. Au moyen de deux tensions continues Vr, Vm, de la masse et d'un ensemble de commutation 1f on génère deux signaux carrés V1 (t) et V2(t) dont l'amplitude algébrique est fonction de ces tensions. On définit l'amplitude algébrique de ces tensions, synchrones de Vh, comme leur variation algébrique lors d'une transition de Vh de l'état bas à l'état haut.

Sur la fig.2, l'ensemble de commutation du sous-bloc 1f de la fig.1, comprend deux commutateurs 4,6, de type MOSFET par exemple, pourvu chacun de deux entrées et d'une sortie, chacune desdites entrées pouvant être mise en relation avec la sortie respective sous l'impulsion de la tension d'horloge Vh, une entrée, dite première, du premier commutateur 4 étant reliée à la source de tension Vr, une entrée, dite première du second commutateur 6 étant reliée à la source (masse) de tension nulle Vo, les entrées, dites secondes, des dits commutateurs -étant reliées entre elles pour recevoir ladite tension Vm, tandis que la sortie 3 du premier commutateur 4 est reliée à l'entrée de l'impédance Z1, et la sortie 5 du second commutateur 6 est reliée à l'entrée de l'impédance Z2, les sorties des impédances Z1 et Z2 étant reliées à une ligne de sortie 7.

Il résulte de cette disposition que lorsque la tension d'horloge passe de la valeur Vh à la valeur 0, et inversement, les sorties des commutateurs passent pour le premier de la valeur Vr à la valeur Vm et inversement, et pour le second de la valeur 0 à la valeur Vm et inversement, assurant ainsi la génération desdites tensions V1(t) et V2(t).

Les signaux V1(t) et V2(t) sont envoyés dans un pont à deux branches constitué par les impédances à mesurer Z1 et Z2 ; la ligne 7 de sortie des impédances, formant le point milieu de ce pont, est reliée à l'entrée inverseuse 10 d'un amplificateur opérationnel 12 câblé selon une configuration de type "trans-impédance" dont l'impédance de bouclage Zm est de même nature que Z1 et Z2 ; il résulte de cette disposition que la sortie de l'amplificateur 12 est constituée par un signal carré V(t), dit d'erreur, dont l'amplitude algébrique E représente le déséquilibre du pont. Le signal V(t) (sortie 14 de l'amplificateur 12) est appliqué à l'entrée 16 d'un démodulateur (ou détecteur) synchrone 18 commandé (20) par l'horloge 2, lequel démodulateur extrait le signal d'erreur E qui sera utilisé pour former la tension Vm.

L'ensemble des éléments du convertisseur représentés dans le sous-bloc 1b forme la caractéristique principale de l'objet de l'invention, tant dans son aspect méthode, que dans son aspect dispositif.

Suivant la première variante de la méthode susvisée, le signal d'erreur E est alors appliqué à l'entrée d'un intégrateur 24 dont la sortie fournit la tension Vm qui, à la fois, peut servir à la mesure et est utilisée pour générer V1(t) et V2(t) à la seconde entrée des impédances Z1,Z2, ce qui assure une convergence de la boucle vers un état d'équilibre.

L'équation d'équilibre de la boucle est obtenue en écrivant que E=0, c'est-à-dire que la somme des courants dans Z1 et Z2 est nulle :

$$V1/Z1 + V2/Z2 = 0 \qquad (1),$$

dans laquelle : V1 et V2 sont les amplitudes algébriques de V1(t) et de V2(t), et Z1 et Z2 les impédances (complexes) du pont.

L'équation (1) est généralisable à un nombre quelconque d'impédances, sous la forme :

$$V1/Z1 + V2/Z2 +...+ Vi/Zi = 0 \qquad (1')$$

en ajoutant à l'ensemble de commutation, un nombre i de commutateurs analogues à 4 et 6 et recevant sur leurs entrées l'une quelconque des tensions Vo, Vm, Vr pour restituer sur leurs sorties des signaux V1(t), V2(t), Vi(t) d'amplitudes algébriques V1, V2, Vi.

Pour des capacités, (1) s'écrit :

$$V1C1 + V2C2 = 0 \qquad (3)$$

Pour des inductances, (1) s'écrit :

$$V1L2 + V2L1 = 0 \qquad (3)$$

La valeur de V1 et V2 dépend du câblage des commutateurs de l'ensemble de commutation et il est ainsi possible de sélectionner le rapport à mesurer, suivant la nature de l'application. Dans le cas de la fig.1 le câblage correspond à :

$$V1 = Vr - Vm \text{ et } V2 = - Vm \qquad (4)$$

ce qui permet d'obtenir, par exemple en reportant (4) dans (3) pour le cas capacitif :

$$Vm = (C1/(C1+C2))Vr \qquad (5)$$

La nature du montage transimpédance autorise l'introduction d'un gain supplémentaire dans la boucle et, à condition que le critère de stabilité de la boucle soit rempli, permet de réduire à un niveau négligeable les imperfections physiques des composants de la boucle (par exemple : tension et courants de décalage des amplificateurs opérationnels) ; ce gain peut être obtenu en réglant la valeur de Zm.

Revenant au cas de la fig.1 avec Z1 et Z2 comme étant des capacités, et avec un éloignement substantiel de la cellule 1a par rapport à l'appareil 1c, les lignes reliant lesdites capacités d'une part aux entrées desdits commutateurs électroniques 4 et 6, et à l'entrée inverseuse dudit amplificateur opérationnel 12, (respectivement lignes 3,3',5,5' et 7,7') sont des lignes dites coaxiales dont les blindages 3',5'et 7' sont reliés à la masse ; ceci s'exprime par la présence du sousbloc 1d et l'absence du sous-bloc 1e.

Suivant une variante de protection, les lignes reliant lesdites capacités d'une part aux entrées desdits commutateurs électroniques 4,6 et à l'entrée inverseuse dudit amplificateur opérationnel 12, (respectivement lignes 3,3',5,5' et 7,7') sont encore des lignes coaxiales, les blindages 3',5' des lignes reliant lesdites capacités aux dits commutateurs étant reliés à la masse, tandis que le blindage 7' de la ligne 7 reliant lesdites capacités au dit amplificateur opérationnel est relié à l'entrée inverseuse et à la sortie d'un second amplificateur opérationnel 13 monté en amplificateur suiveur pour réaliser une "garde active" ; ceci s'exprime par l'absence du sous-bloc 1d et la présence du sous-bloc 1e.

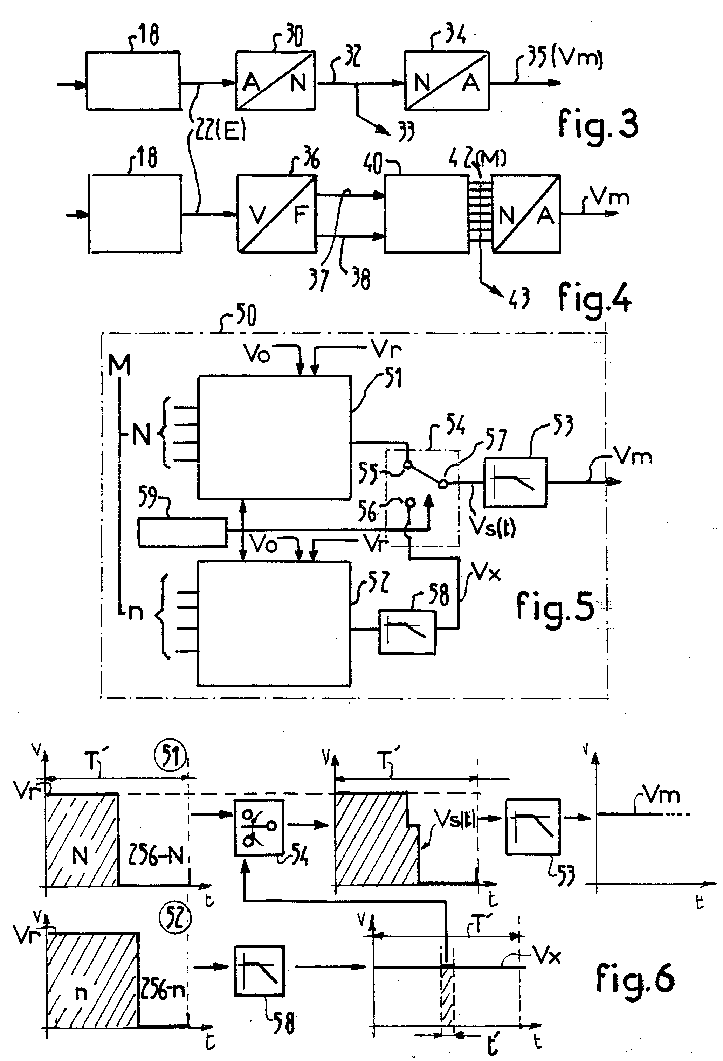

Sur la fig.3, et suivant la deuxième variante de la méthode générale susvisée, variante consistant à remplacer l'intégration analogique par une intégration numérique, le signal E de sortie 22 du détecteur synchrone 18 est appliqué à l'entrée d'un convertisseur analogique-numérique (A/N) 30 de type intégrateur dont la sortie 32 est dirigée d'une part vers un traitement de données 33, et d'autre part vers un convertisseur numériqueanalogique (N/A) 34 dont la sortie analogique 35, qui constitue Vm, est rebouclée, via l'ensemble de commutation 1f, sur les impédances Z1,Z2.

Sur la fig.4, et suivant la troisième variante de la méthode générale, on applique le signal d'erreur E comme tension de commande à l'entrée d'un oscillateur, ou convertisseur tension-fréquence V/F, 36 incorporant des moyens pour, suivant le signe de la tension appliquée, adresser à l'une ou l'autre des deux sorties 37, 38 des impulsions sur respectivement l'entrée de comptage ou l'entrée de décomptage d'un compteur-décompteur binaire 40 à sorties parallèles 42 fournissant un "mot" binaire M et remplissant la fonction d'intégrateur ; le mot M est dirigé d'une part vers un traitement de données 43, et d'autre part sur un convertisseur numérique-analogique 44 dont la sortie représente Vm.

Sur la fig.5 un tel convertisseur CNARCF comprend fonctionnellement : deux convertisseurs numérique-rapport cyclique 51 et 52, un commutateur analogique 54 à commande logique à deux entrées et une sortie, une base de temps 59 de période T' commune aux deux convertisseurs et commandant aussi le commutateur 54, et deux filtres passe-bas 53 et 58, dits respectivement premier et second.

Les convertisseurs 51 et 52 sont essentiellement constitués chacun d'un compteur-décompteur binaire, le premier convertisseur 51 recevant les connexions de l'octet de poids fort représentant N, et le second convertisseur 52 recevant les connexions de l'octet de poids faible représentant n, d'un "mot" binaire de seize bits de valeur M=256N+n ; chacun des convertisseurs reçoit une tension de référence Vr définissant l'amplitude de son signal rectangulaire de sortie, par rapport à la masse Vo.

La sortie du premier convertisseur 51 est reliée à la première entrée 55 du commutateur 54, et la sortie du second convertisseur 52 est reliée à la seconde entrée 56 du commutateur à travers ledit second filtre passe-bas 58; la sortie 57 Vs(t) du commutateur 54 est elle-même reliée à l'entrée du premier filtre passe-bas 53.

Le commutateur est commandé par l'horloge 59 pour être "passant" entre sa deuxième entrée 56 (sortie du second filtre) et sa sortie 57 pendant une durée t'= T'/256 commençant au flanc descendant du premier convertisseur, et pour être "passant" entre sa première entrée 55 (sortie du premier convertisseur) pendant la durée complémentaire (T'-t') de la période T'; il en résulte que le signal Vs(t) est "moyenné", en sortie du premier filtre 53, à une valeur Vm égale à Vr.(256N+n)/ 65536.

Sur la fig.6, qui illustre aussi la méthode c.n.a.r.c.f., il apparaît bien que le commutateur 54 adresse alternativement au premier filtre 53, tantôt les tensions Vr et Vo en proportion de leur rapport cyclique N/256, tantôt, et pendant la seule durée t', la tension Vx constituant la valeur moyenne des tensions Vo et Vr en proportion de leur rapport cyclique n/256, ces tensions Vs(t) en sortie du commutateur prennent, après passage dans le filtre 58, une valeur moyenne Vm en proportion de leurs amplitudes et durées respectives pendant la période T'.

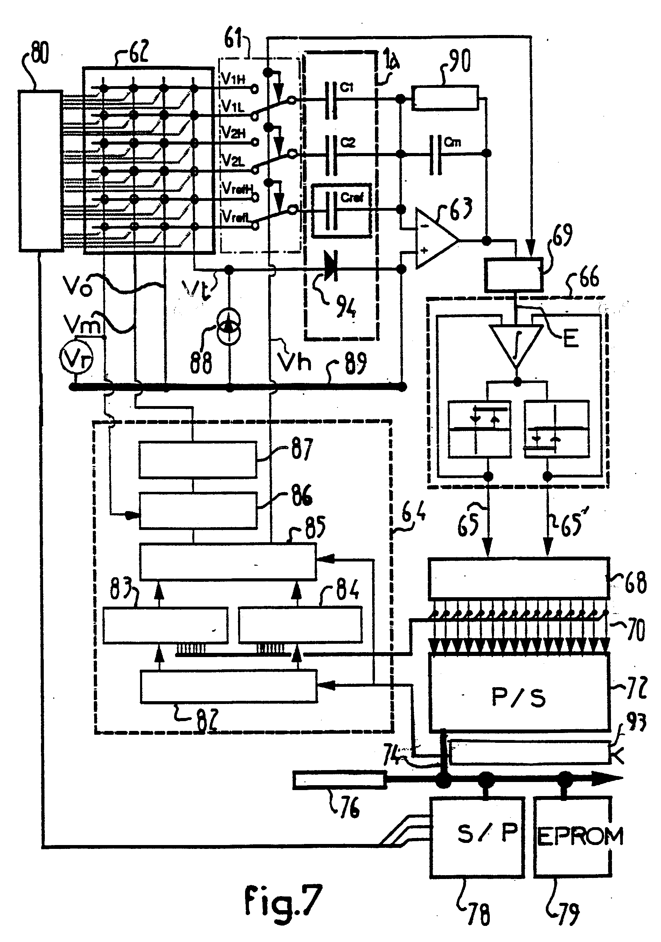

Sur la fig.7 on a schématisé dans un synoptique, les circuits d'un convertisseur de rapports d'impédances capacitives, constitutif d'une quatrième variante des méthodes et dispositifs de l'invention.

Dans la suite de la description, les références placées entre parenthèses renvoient aux éléments correspondant des figures précédentes ; cependant cette variante se distingue des précédentes, par deux points :

a) le dispositif - est étendu à la mesure de trois capacités C1, C2, Cref, ce pourquoi l'ensemble de commutation 61 comprend trois commutateurs analogues à 4 et 6, tandis au'une matrice de commutation est destinée à appliquer aux entrées des commutateurs dudit ensemble, une sélection des signaux Vm, Vr, Vo, et

b) le convertisseur numérique-analogique est un CNARCF 64(50).

On reconnait sur le synoptique la cellule de mesure 1a de la fig.1 avec ses capacités C1 et C2, voisines d'une capacité Cref ; cette capacité Cref, de dimensions fixes et stables, plongée dans le milieu hydraulique diélectrique dont sont habituellement pourvues les cellules à couplage hydraulique, permet par l'effet de la matrice 62 de mesurer C1/Cref et C2/Cref et d'en déduire directement les distances interélectrodes.

On reconnaît encore sur le synoptique un amplificateur opérationnel 63(12), un convertisseur V/F 66(36) recevant la tension de sortie d'un détecteur synchrone 69(22) et fournissant des impulsions de comptage 65 (37) et de décomptage 65'(38) à un compteur-décompteur 68(40) à seize bits dont la sortie parallèle 70(42) est adressée d'une part à un CNARCF 64(50), et d'autre part à un convertisseur parallèle-série P/S 72 dont la sortie 74 est reliée à une "liaison série" 76 pour un microprocesseur, extérieur, de commande du CNARCF, à un convertisseur série-parallèle S/P 78, et à une mémoire EEPROM 79 destinée au stockage de certains coefficients propres à la cellule de mesure ou à l'électronique de conversion. Un décodeur 80, sous la dépendance d'un convertisseur série-parallèle S/P 78, commande les opérations de la matrice de commutation 62.

La matrice de commutation 62 permet, outre le calcul des différents rapports des capacités : C1/(C1+C2), C2/(C1+C2), Cref/(Cref+C1), Cref/(Cref+C2), Cref/(C1+C2), par la sélection des tensions présentées à l'ensemble de commutation 61, de calculer la grandeur Nt = 65536.Vt/Vr à partir de la mesure fournie par un capteur de température 94 à diode relié d'une part à une source de courant continu 88, et d'autre part à l'entrée non-inverseuse de l'amplificateur opérationnel 63 et à une masse locale 89 qui sert aussi de référence à ladite entrée non-inverseuse, à la source de courant et à la matrice de commutation.

On reconnaît dans les éléments constitutifs du CNARCF 64 : des compteurs-décompteurs huit-bits 83 (51) et 84(52), une base de temps 82(59) et une logique de synchonisation 85 placées sous la dépendance d'une horloge d'échantillonnage 93, un ensemble interrupteur 86(54) et un filtre actif passe-bas 87(58). L'ensemble interrupteur 86 reçoit la tension Vr de même que la matrice 62, tandis que le filtre actif 87 renvoie à celle-ci la tension Vm.

Une stabilisation 90 en courant continu, est reliée aux capacités et aux entrée non-inverseuse et sortie de l'amplificateur opérationnel 63 pour, puisque son entrée non inverseuse est seulement reliée à des capacités, lui assurer un courant de polarisation.

## Revendications

1. Méthode de mesure du rapport de deux impédances Z1, Z2 particulièrement capacités C1, C2 mais aussi résistances et inductances, de même nature, les deux impédances étant comprises dans une cellule de mesure reliée à un appareil de mesure, caractérisée:

   en ce qu'elle comprend la succession des étapes consistant à:

   - générer des signaux carrés (Vh) au moyen d'une horloge (2), de période (T) bien constante,
   - appliquer pendant la première demi-période d'horloge, une tension Vr à l'entrée de l'impédance Z1, et une tension nulle V0 à l'entrée de l'impédance Z2, puis
   - appliquer pendant la seconde demi-période d'horloge une tension Vm à l'entrée de chacune des deux impédances Z1, Z2,
     d'ou il résulte que les entrées desdites impédances Z1, Z2 sont portées à des tensions périodiques respectivement de valeurs V1(t) pour Z1 et V2(t) pour Z2,
   - appliquer les impédances Z1, Z2 ayant leurs sorties reliées à une ligne (7) de sortie d'impédance, le signal de ladite ligne (7) à l'entrée inverseuse (10) d'un amplificateur opérationnel (12) monté en sommateur rebouclé sur une impédance de même nature que Z1 et Z2, lesdites étapes étant opérées par un ensemble de commutation placé sous la dépendance desdits signaux d'horloge,
   d'où il résulte que la sortie (14) de l'amplificateur opérationnel (12) est portée à une tension périodique V(t), de période T égale à celle de l'horloge (2), discontinue à deux seuils dont la différence E, dite signal d'erreur, ne dépend que de Vr et de Vm et est proportionnelle à (Vr·Z1/(Z1+Z2)) Vm,
   - appliquer la sortie (14) de l'amplificateur opérationnel (12) à l'entrée (16) d'un détecteur synchrone (18) commandé (20) par l'horloge (2), en vue d'extraire le signal E.

2. Méthode selon la revendication 1, caractérisée:

   en ce qu'une étape ultérieure consiste à appliquer la sortie (22) du détecteur synchrone (18) à l'entrée d'un intégrateur (24) dont la sortie (26) fournit la tension Vm qui sert à la mesure et qui est utilisée pour générer V1(t) et V2(t) à la seconde entrée des impédances,
   d'ou il résulte que le couplage des entrées et sorties de tensions étant ainsi realisées, la tension Vm générée par la boucle formée par les éléments précédents (Z1, Z2, 8, 12, 18, 24) converge vers un état d'équilibre, et fournit de ce fait une valeur du rapport Z1/(Z1+Z2) dépendant uniquement des tensions Vr et V0, à l'exclusion de toute autre grandeur électrique du circuit.

3. Méthode selon la revendication 1, caracterisée:
   en ce qu'une étape ultérieure consiste à appliquer la sortie (22) du détecteur synchrone (18) à l'entrée d'un convertisseur analogique/numérique (30) de type intégrateur, dont la sortie (32) constitue la représentation numérique de la sortie (22) du détecteur synchrone, utilisable pour un traitement de données (calcul de Vm/Vr et Z1/(Z1+Z2)), puis à convertir avec un convertisseur numérique-analogique (34) cette représentation numérique en la tension Vm qui est appliquée à la seconde entrée des impédances.

4. Méthode selon la revendication 1, caractérisée:
   en ce qu'elle comprend les étapes suivantes consistant à:

   - appliquer la sortie (22) du détecteur synchrone (18) à l'entrée d'un oscillateur (36) dont la fréquence est commandée par, et proportionnellement à lui, le signal issu du détecteur synchrone (18),

- appliquer la sortie (38) de l'oscillateur (36) à l'entrée d'un compteur-décompteur binaire (40) à sortie parallèles (42) fournissant un mot binaire M, et à
- convertir le mot binaire M à sa représentation analogique qui constitue la tension Vm.

**5.** Méthode selon la revendication 4, caractérisée:
en ce que ledit mot binaire M est un mot de seize bits d'une valeur M=256 N+n, N représentant le byte le plus significatif et n représentant le byte le moins significatif, et en ce que l'étape de convertir le mot binaire M à la tension Vm consiste en

- générer, au moyen d'un premier convertisseur numérique-rapport cyclique (51) recevant les connexions pour le byte N le plus significatif, un signal en tension, rectangulaire, de période T', dont le rapport cyclique vaut N/256 et dont les deux paliers, haut et bas, sont respectivement:

  - une tension positive stable Vr,
  - la tension nulle, puis

- à générer, au moyen d'un second convertisseur numérique-rapport cyclique (52) recevant les connexions pour le byte n le moins significatif, un second signal rectangulaire, de période T', dont le rapport cyclique, de caractéristiques d'amplitude identiques à celles du premier signal, vaut n/256,
- à filtrer (53) ledit second signal rectangulaire afin d'en extraire sa valeur moyenne $Vx=Vr\cdot n/256$,
- à appliquer ledit premier signal rectangulaire à la première entrée (55) d'un commutateur analogique (54), et une tension continue Vx à la seconde entrée (56) dudit commutateur, ledit commutateur étant alternativement passant entre l'une ou l'autre de ses entrées et sa sortie,
- à appliquer un signal de commande, de période T' audit commutateur analogique, de telle sorte que ledit commutateur analogique:

  soit passant entre sa seconde entrée et sa sortie pendant une durée t'=T'/256 lors du passage dudit premier signal, de son palier haut vers son palier bas, et
  soit passant entre sa première entrée et sa sortie pendant la durée complémentaire (T'- t') de la période T',
  d'où il résulte l'apparition d'une tension variable en fonction du temps Vs(t) à la sortie dudit commutateur, puis enfin

- à filter (58) la tension Vs(t) en vue d'en extraire sa valeur moyenne

$$Vm = Vr(256N+n)/65536$$

qui constitue la sortie analogique.

**6.** Dispositif de mise en oeuvre la méthode de mesure du rapport de deux impédances Z1, Z2, de même nature, étant compris dans une cellule de mesure reliée à un appareil de mesure, selon la revendication 1, caractérisée par:

- une horloge (2) pour générer les signaux rectangulaires Vh de période (T) bien constante,
- un ensemble de commutation (1c) qui comprend deux commutateurs électroniques (4, 6) pourvue chacun de deux entrées et d'une sortie, chacune des deux entrées dans chaque commutateur (4, 6) pouvant être mise en relation avec la sortie correspondante du commutateur (4, 6) sous l'impulsion de la tension d'horloge Vh, une entrée, dite première, du premier commutateur (4) étant reliée à une source de tension Vr, une entrée, dite première du second commutateur (6) étant relièe à une source (masse) de tension nulle (V0), les entrées, dites secondes, desdits commutateurs étant reliées entre elles pour recevoir une tension Vm, tandis que la sortie du premier commutateur (4) est reliée à l'entrée de l'impédance Z1, et la sortie du second commutateur (6) est reliée à 1"entrée de l'impédance Z2, les sorties des impédances Z1 et Z2 étant reliées à une ligne de sortie (7),
  d'où il résulte que lorsque la tension d'horloge passe de la valeur Vh à la valeur 0, et inversement, les sorties des commutateurs passent pour le premier de la valeur Vr à la valeur Vm et inversement, et pour le second de la valeur 0 à la valeur Vm assurant ainsi la génération de tensions V1(t) et V2(t),
- un amplificateur opérationnel (12) monté en sommateur rebouclé sur une impédance de même nature que Z1 et Z2 et recevant à son entrée inverseuse (10) le signal de ladite ligne (7) de la sortie d'impédance,
  d'ou il résulte que la sortie (14) de l'amplificateur opérationnel (12) est portée à une tension périodique V(t), de période T égale à celle de l'horloge (2), discontinue à deux seuils dont la différence E, dite signal d'erreur, ne dépend que de Vr et de Vm et est proportionnelle à $(Vr\cdot Z1/(Z1+Z2))Vm$,
- un détecteur synchrone (18) commandé par l'horloge (2) et recevant à son entrée (16) le signal issu de l'amplificateur opérationnel (12) en vue d'extraire le signal E.

**7.** Dispositif selon la revendication 6, caractérisée:

en ce que, les impédances Z1, Z2 soumises à la mesure étant des capacités C1 et C2, et la cellule de mesure étant éloignée de l'appareil de mesure comprenant ledit ensemble -de commutation et l'amplificateur opérationnel (12), les lignes reliant lesdites capacités d'une part aux sorties desdits commutateurs électroniques (4, 6) et à l'entrée inverseuse dudit amplificateur opérationnel (12), (respectivement lignes 3, 3', 5, 5' et 7, 7') sont des lignes dites coaxiales dont les blindages (3', 5' et 7') sont reliés à la masse.

8. Dispositif selon la revendication 6, caractérisé:
en ce que les impédances Z1, Z2 soumises à la mesure étant des capacités C1 et C2, et la cellule de mesure étant éloignée de l'appareil de mesure comprenant ledit ensemble de commutation et ledit amplificateur opérationnel (12), les lignes reliant lesdites capacités d'une part aux sorties desdits commutateurs électroniques (4, 6) et à l'entrée inverseuse dudit amplificateur opérationnel (12), (respectivement lignes 3, 3', 5, 5' et 7, 7') sont des lignes dites coaxiales, les blindages (3', 5') des lignes reliant lesdites capacités aux dits commutateurs étant reliès à la masse tandis que le blindage de la ligne (7) reliant lesdites capacités au dit amplificateur opérationnel est relié à l'entrée inverseuse et à la sortie d'un second amplificateur opérationnel (13) monté en amplificateur suiveur pour réaliser une garde active.

9. Dispositif selon les revendications 6, 7 ou 8, caractérisé par

- un oscillateur (36) dont la fréquence est controllée par le signal issu du détecteur synchrone (18) et proportionnelle au dit signal,
- un compteur-décompteur binaire (40) à sorties parallèles (42) recevant le signal issu dudit oscillateur (36) et fournissant un mot binaire M de seize bits, et
- un convertisseur numérique-analogique pour convertir ledit mot binaire M à sa représentation analogique, ledit convertisseur numérique-analogique comprenant:

deux filtres passe-bas (53, 58), dits respectivement premier et second,
les convertisseurs (51 et 52) étant essentiellement constitués chacun d'un compteur-décompteur binaire, le premier convertisseur (51) recevant les connexions de l'octet de poids fort représentant N, et le second convertisseur (52) recevant les connexions de l'octet de poids faible représentant n, ledit mot binaire de seize bits de valeur M=256N+n, chacun des convertisseurs recevant une tension de référence Vr définissant l'amplitude de son signal rectangulaire de sortie, par rapport à la masse Vo,
la sortie du premier convertisseur (51) étant reliée à la première entrée (55) du commutateur (54), et la sortie du second convertisseur étant reliée à la seconde entrée (56) du commutateur à travers ledit second filtre passe-bas (58), la sortie (57) du commutateur étant elle-même reliée à l'entrée du premier filtre pase-bas (53),
le commutateur (54) étant commandé par la base de temps (59) pour être passant entre sa deuxième entrée (56) et sa sortie (57) pendant une durée t' =T'/256 commençant au flanc descendant du premier convertisseur, et pour être passant entre sa première entrée (55) et sa sortie pendant la durée complémentaire (T'-t') de la période T',

d'où il résulte que le signal Vs(t) est moyenné, en sortie du premier filtre (53) à une valeur Vm égale à $Vr \cdot (256N+n)/65536$.

10. Dispositif selon la revendication 9, plus particulièrement destiné à la mesure de rapports de capacités C1, C2, Cref, d'une cellule de mesure, caractérisé:
en ce qu'il comprend:

- un ensemble (61) de trois commutateurs, et
- une matrice de commutation (62) destinée à appliquer aux entrées des dits trois commutateurs une sélection des signaux Vm, Vr, Vo et Vt, le signal Vt étant une mesure de température fournie par un capteur de température (94),

d'où il résulte que l'on peut calculer les rapports suivants des capacités:
C1/(C1+C2), C2/(C1+C2), Cref/(Cref+C1), Cref/(Cref+C2), ainsi que la grandeur Nt = 65536·Vt/Vr.

## Patentansprüche

1. Verfahren zum Messen des Verhältnisses zweier gleichartiger Impedanzen Z1, Z2, insbesondere Kapazitäten C1, C2, aber auch ohmscher Widerstände und Induktivitäten, wobei die beiden Impedanzen in einer mit einer Meßvorrichtung verbundenen Meßzelle enthalten sind, **dadurch gekennzeichnet, daß** es die Abfolge von Schritten umfaßt, welche darin bestehen,

- Rechtecksignale (Vh) mittels eines Takts (2) im wesentlichen konstanter Periode (T) zu erzeugen,

- während der ersten Halbperiode des Takts eine Spannung Vr an den Eingang der Impedanz Z1 sowie eine Nullspannung V0 an den Eingang der Impedanz Z2 anzulegen, sodann
- während der zweiten Halbperiode des Takts eine Spannung Vm an den Eingang jeder der beiden Impedanzen Z1, Z2 anzulegen, mit der Folge, daß die Eingänge der Impedanzen Z1, Z2 auf periodische Spannungen der Werte V1(t) für Z1 bzw. V2(t) für Z2 gebracht werden,
- das Signal einer Impedanzausgangsleitung (7), mit welcher Leitung (7) die Ausgänge der Impedanzen Z1, Z2 verbunden sind, an den invertierenden Eingang (10) eines als Summierer geschalteten Operationsverstärkers (12) anzulegen, welcher über eine Impedanz gleicher Art wie Z1 und Z2 rückgekoppelt ist, wobei diese Schritte mittels einer unter der Abhängigkeit der Taktsignale stehenden Schalteinheit durchgeführt werden, mit der Folge, daß der Ausgang (14) des Operationsverstärkers (12) auf eine periodische Spannung V(t) gebracht wird, deren Periode T gleich derjenigen des Takts (2) ist und die diskontinuierlich mit zwei Stufen ist, deren Fehlersignal genannte Differenz E nur von Vr und von Vm abhängt und proportional zu $(Vr \cdot Z1/(Z1+Z2))$ Vm ist,
- den Ausgang (14) des Operationsverstärkers (12) an den Eingang (16) eines durch den Takt (2) gesteuerten (20) Synchrondetektors (18) anzulegen, um das Signal E zu extrahieren.

2. Verfahren nach Anspruch 1, dadurch gekennzeichnet, daß ein nachfolgender Schritt darin besteht, den Ausgang (22) des Synchrondetektors (18) an den Eingang eines Integrators (24) anzulegen, dessen Ausgang (26) die Spannung Vm liefert, die zu der Messung dient und dazu benutzt wird, V1(t) und V2(t) am zweiten Eingang der Impedanzen zu erzeugen, mit der Folge, daß bei solchermaßen hergestellter Kopplung der Spannungseingänge und -ausgänge die Spannung Vm, die von der von den vorangehenden Elementen (Z1, Z2, 8, 12, 18, 24) gebildeten Masche erzeugt wird, sich einem Gleichgewichtszustand annähert und so einen Wert des Verhältnisses Z1/(Z1+Z2) liefert, welcher einzig von den Spannungen Vr und V0 unter Ausschluß jeder anderen elektrischen Größe der Schaltung abhängt.

3. Verfahren nach Anspruch 1, dadurch gekennzeichnet, daß ein nachfolgender Schritt darin besteht, den Ausgang (22) des Synchrondetektors (18) an den Eingang eines Analog-Digital-Umsetzers (30) vom Integratortyp anzulegen, dessen Ausgang (32) die bei einer Datenverarbeitung (Berechnung von Vm/Vr und Z1/(Z1+Z2)) nutzbare digitale Darstellung des Ausgangs (22) des Synchrondetektors bildet, sodann diese digitale Darstellung mit einem Digital-Analog-Umsetzer (34) in die Spannung Vm umzusetzen, die an den zweiten Eingang der Impedanzen angelegt wird.

4. Verfahren nach Anspruch 1, dadurch gekennzeichnet, daß es die folgenden Schritte umfaßt, welche darin bestehen,

- den Ausgang (22) des Synchrondetektors (18) an den Eingang eines Oszillators (36) anzulegen, dessen Frequenz durch das von dem Synchrondetektor (18) ausgegebene Signal gesteuert wird und zu diesem proportional ist,
- den Ausgang (38) des Oszillators (36) an den Eingang eines ein Binärwort M liefernden binären Auf/Ab-Zählers (40) mit parallelen Ausgängen (42) anzulegen und - das Binärwort M in seine analoge Darstellung umzusetzen, die die Spannung Vm bildet.

5. Verfahren nach Anspruch 4, dadurch gekennzeichnet, daß das Binärwort M ein 16-Bit Wort eines Werts M = 256 N+n ist, wobei N das höchstwertige Byte darstellt und n das geringstwertige Byte darstellt, und daß der Schritt der Umsetzung des Binärworts M in die Spannung Vm darin besteht,

- mittels eines die Anschlüsse für das höchstwertige Byte N erhaltenden ersten Digital-Zyklusverhältnis-Umsetzers (51) ein Rechteckspannungssignal der Periode T' zu erzeugen, dessen Zyklusverhältnis N/256 beträgt und dessen beide Pegel, nämlich Hochpegel und Tiefpegel,

    - eine stabile positive Spannung Vr bzw.
    - die Nullspannung sind,

    sodann
- mittels eines die Anschlüsse für das geringstwertige Byte n erhaltenden zweiten Digital-Zyklusverhältnis-Umsetzers (52) ein zweites Rechtecksignal der Periode T' zu erzeugen, dessen Zyklusverhältnis bei Amplitudeneigenschaften, die zu denen des ersten Signals identisch sind, n/256 beträgt,
- das zweite Rechtecksignal zu filtern (53), um seinen Mittelwert $Vx = Vr \cdot n/256$ zu extrahieren,
- das erste Rechtecksignal an den ersten Eingang (55) eines analogen Schalters (54) sowie eine kontinuierliche Spannung Vx an den zweiten Eingang (56) dieses Schalters anzulegen, wobei der Schalter abwechselnd zwischen dem einen oder dem anderen seiner Eingänge und seinem Ausgang durchgeschaltet ist,
- ein Steuersignal der Periode T' an den analogen Schalter anzulegen, derart, daß der analoge Schalter während einer Zeitdauer t' = T'/256 beim Übergang des ersten Signals von dessen Hochpegel auf dessen Tiefpegel zwischen seinem zweiten Eingang und seinem Ausgang durchgeschaltet ist und während der Restzeitdauer (T' - t') der Periode T' zwischen seinem ersten Eingang und seinem Ausgang durchgeschaltet ist, mit der Folge des Auftretens einer zeitabhängig veränderlichen Spannung Vs(t) am Ausgang des Schalters, sodann schließlich

- die Spannung Vs(t) zu filtern (58), um ihren Mittelwert

$$Vm = Vr(256N+n)/65536$$

zu extrahieren, der den analogen Ausgang bildet.

6.  Einrichtung zur Durchführung des Verfahrens nach Anspruch 1 zum Messen des Verhältnisses zweier gleichartiger Impedanzen Z1, Z2, welche in einer mit einer Meßvorrichtung verbundenen Meßzelle enthalten sind, gekennzeichnet durch:

- einen Takt (2) zum Erzeugen von Rechtecksignalen Vh im wesentlichen konstanter Periode (T),
- eine Schalteinheit (1c) mit zwei elektronischen Schaltern (4, 6), welche jeweils mit zwei Eingängen und einem Ausgang ausgeführt sind, wobei jeder der beiden Eingänge jedes Schalters (4, 6) mit dem entsprechenden Ausgang des Schalters (4, 6) auf die Ansteuerung der Taktspannung Vh hin in Verbindung gebracht werden kann, wobei ein Eingang, genannt erster Eingang, des ersten Schalters (4, 6) mit einer Spannungsquelle Vr verbunden ist, ein Eingang, genannt erster Eingang, des zweiten Schalters (6) mit einer Quelle (Masse) einer Nullspannung (V0) verbunden ist, wobei die zweite Eingänge genannten Eingänge der Schalter miteinander verbunden sind, um eine Spannung Vm zu erhalten, während der Ausgang des ersten Schalters (4) mit dem Eingang der Impedanz Z1 verbunden ist und der Ausgang des zweiten Schalters (6) mit dem Eingang der Impedanz Z2 verbunden ist, wobei die Ausgänge der Impedanzen Z1 und Z2 mit einer Ausgangsleitung (7) verbunden sind, mit der Folge, daß dann, wenn die Taktspannung vom Wert Vh auf den Wert 0 übergeht und umgekehrt, die Ausgänge der Schalter beim ersten vom Wert Vr auf den Wert Vm und umgekehrt und beim zweiten vom Wert 0 auf den Wert Vm übergehen und so für die Erzeugung der Spannungen V1(t) und V2(t) sorgen,
- einen als Summierer geschalteten Operationsverstärker (12), welcher über eine Impedanz gleicher Art wie Z1 und Z2 rückgekoppelt ist und an seinem invertierenden Eingang (10) das Signal der Impedanzausgangsleitung (7) erhält, mit der Folge, daß der Ausgang (14) des Operationsverstärkers (12) auf eine periodische Spannung V(t) gebracht ist, deren Periode T gleich derjenigen des Takts (2) ist und die diskontinuierlich mit zwei Stufen ist, deren Fehlersignal genannte Differenz E nur von Vr und von Vm abhängt und proportional zu (Vr·Z1/(Z1+Z2))Vm ist,

- einen durch den Takt (2) gesteuerten Synchrondetektor (18), welcher an seinem Eingang (16) das von dem Operationsverstärker (12) ausgegebene Signal erhält, um das Signal E zu extrahieren.

7.  Einrichtung nach Anspruch 6, dadurch gekennzeichnet, daß die der Messung unterzogenen Impedanzen Z1, Z2 Kapazitäten C1 und C2 sind und die Meßzelle von der die Schalteinheit und den Operationsverstärker (12) enthaltenden Meßvorrichtung entfernt ist, wobei die Leitungen, welche die Kapazitäten zum einen mit den Ausgängen der elektronischen Schalter (4, 6) sowie mit dem invertierenden Eingang des Operationsverstärkers (12) verbinden (Leitungen 3, 3', 5, 5' bzw. 7, 7'), Koaxialleitungen genannte Leitungen sind, deren Abschirmungen (3', 5' und 7') mit Masse verbunden sind.

8.  Einrichtung nach Anspruch 6, dadurch gekennzeichnet, daß die der Messung unterzogenen Impedanzen Z1, Z2 Kapazitäten C1 und C2 sind und die Meßzelle von der die Schalteinheit und den Operationsverstärker (12) enthaltenden Meßvorrichtung entfernt ist, wobei die Leitungen, welche die Kapazitäten zum einen mit den Ausgängen der elektronischen Schalter (4, 6) sowie mit dem invertierenden Eingang des Operationsverstärkers (12) verbinden (Leitungen 3, 3', 5, 5' bzw. 7, 7'), Koaxialleitungen genannte Leitungen sind, wobei die Abschirmungen (3', 5') der die Kapazitäten mit den Schaltern verbindenden Leitungen mit Masse verbunden sind, während die Abschirmung der die Kapazitäten mit dem Operationsverstärker verbindenden Leitung (7) mit dem invertierenden Eingang und mit dem Ausgang eines zweiten Operationsverstärkers (13) verbunden ist, welcher als Nachführverstärker geschaltet ist, um einen aktiven Schutz zu realisieren.

9.  Einrichtung nach den Ansprüchen 6, 7 oder 8, gekennzeichnet durch

- einen Oszillator (36), dessen Frequenz durch das von dem Synchrondetektor (18) ausgegebene Signal gesteuert ist und proportional zu diesem Signal ist,

- einen binären Auf/Ab-Zähler (40) mit parallelen Ausgängen (42), welcher das von dem Oszillator (36) ausgegebene Signal erhält und ein 16-Bit Binärwort M liefert, sowie

- einen Digital-Analog-Umsetzer zum Umsetzen des Binärworts M in dessen analoge Darstellung, wobei der Digital-Analog-Umsetzer umfaßt:

zwei Tiefpaßfilter (53, 58), nämlich ein erstes und ein zweites, wobei die Umsetzer (51 und 52) jeweils im wesentlichen von einem binären Auf/Ab-Zähler gebildet sind, wobei der erste Umsetzer (51) die Anschlüsse des N darstellenden Oktetts starker Wertigkeit erhält und der zweite Umsetzer (52) die Anschlüsse des n darstellenden Oktetts schwacher Wertigkeit erhält, wobei das 16-Bit Binärwort den Wert $M = 256N+n$ besitzt, wobei jeder der Umsetzer eine Referenzspannung Vr erhält, welche die Amplitude seines ausgangsseitigen Rechtecksignals gegenüber Masse Vo festlegt, wobei der Ausgang des ersten Umsetzers (51) mit dem ersten Eingang (55) des Schalters (54) verbunden ist und der Ausgang des zweiten Umsetzers über das zweite Tiefpaßfilter (58) mit dem zweiten Eingang (56) des Schalters verbunden ist, wobei der Ausgang (57) des Schalters seinerseits mit dem Eingang des ersten Tiefpaßfilters (53) verbunden ist, wobei der Schalter (54) durch die Zeitbasis (59) so gesteuert ist, daß er während einer bei der abfallenden Flanke des ersten Umsetzers beginnenden Zeitdauer $t' = T'/256$ zwischen seinem zweiten Eingang (56) und seinem Ausgang (57) durchgeschaltet ist und während der Restzeitdauer $(T' - t')$ der Periode $T'$ zwischen seinem ersten Eingang (55) und seinem Ausgang durchgeschaltet ist, mit der Folge, daß das Signal Vs(t) am Ausgang des ersten Filters (53) auf einen Wert Vm gleich $Vr \cdot (256N+n)/65536$ gemittelt ist.

10. Einrichtung nach Anspruch 9, die insbesondere zur Messung von Verhältnissen von Kapazitäten C1, C2, Cref einer Meßzelle bestimmt ist, dadurch gekennzeichnet, daß sie umfaßt:

- eine Einheit (61) von drei Schaltern sowie
- eine Schaltmatrix (62), die dazu bestimmt ist, an die Eingänge der drei Schalter eine Auswahl der Signale Vm, Vr, Vo und Vt anzulegen, wobei das Signal Vt ein von einem Temperaturmeßfühler (94) gelieferter Temperaturmeßwert ist,

mit der Folge, daß die folgenden Kapazitätsverhältnisse berechnet werden können:

$C1/(C1+C2)$, $C2/(C1+C2)$, $Cref/(Cref+C1)$, $Cref/(Cref+C2)$ sowie die Größe $Nt = 65536 \cdot Vt/Vr$.

## Claims

1. Method of measuring the ratio of two impedances Zl, Z2, particularly capacitances C1, C2, but also resistances or inductances, of the same nature, the two impedances being contained in a measurement cell connected to a measurement device, characterised in that it comprises the sequence of steps consisting of:

- generating square signals (Vh) by means of a clock (2) with substantially constant cycle (T),
- applying, during the first half clock cycle, a voltage Vr at the input of impedance Z1, and a zero voltage VO at the input of impedance Z2, then
- applying, during the second half clock cycle, a voltage Vm at the input of each of the two impedances Z1, Z2,
  as a result of which the inputs of said impedances Z1, Z2 are respectively brought to periodic voltages with values V1(t) for Z1 and V2(t) for Z2,
- applying impedances Z1, Z2 with their outputs connected to an output impedance line (7), the signal of said line (7) at the inverter input (10) of an operational amplifier (12) mounted as a looped adder on an impedance of the same nature as Z1 and Z2, said steps being operated by a commutation assembly dependent on said clock signals,
  as a result of which the output (14) of the operational amplifier (12) is brought to a periodic voltage V(t), with a cycle T equal to that of the clock (2) which is discontinuous at two thresholds, of which the difference E, said error signal, is only dependent on Vr and Vm and is proportional to $(Vr \cdot Z1/(Z1+Z2))Vm$,
- applying the output (14) of the operational amplifier (12) to the input (16) of a synchronous detector (18) controlled (20) by the clock (2) in order to extract the signal E.

2. Method according to Claim 1, characterised in that a subsequent step comprises applying the output (22) of the synchronous detector (18) to the input of an integrator (24), the output (26) of which supplies the voltage Vm used for measurement and used to generate V1(t) and V2(t) at the second input of the impedances, as a result of which, since the coupling of the inputs and outputs of voltages is achieved in this manner, the voltage Vm generated by the loop formed by the above elements (Z1, Z2, 8, 12, 18, 24) converges towards a state of equilibrium, and therefore supplies a value of the ratio Z1/(Z1+Z2) solely dependent upon voltages Vr and V0 to the exclusion of any other electrical magnitude of the circuit.

3. Method according to Claim 1, characterised in that a subsequent step comprises applying the output (22) of the synchronous detector (18) to the input of an analog/digital converter (30) of the integrator type, the output (32) of which constitutes the digital representation of the output (22) of the synchronous detector which may be used for processing data (calculation of Vm/Vr and Z1/(Z1+Z2)), and then converting this digital representation using a digital/analog converter (34) into the voltage Vm which is applied to the second input of the impedances.

4. Method according to Claim 1, characterised in that it comprises the following step consisting of:

   - applying the output (22) of the synchronous detector (18) to the input of an oscillator (36), the frequency of which is controlled, and in a manner proportional thereto, by the signal emitted by the synchronous detector (18),
   - applying the output (38) of the oscillator (36) to the input of a binary forward-backward counter (40) with parallel outputs (42) providing a binary word M, and
   - converting the binary word M to its analog representation which constitutes the voltage Vm.

5. Method according to Claim 4, characterised in that said binary word M is a word of sixteen bits with a value of $M=256N+n$, N representing the most significant byte and n representing the least significant byte, and in that the step of converting the binary word M to the voltage Vm comprises:

   - generating, by means of a first digital-cyclic ratio converter (51) receiving the connections for the most significant byte N, a rectangular voltage signal of cycle T', the cyclic ratio of which amounts to N/256 and the two plateaus of which, high and low, are respectively:

      - a positive stable voltage Vr
      - the zero voltage, then

   - generating, by means of a second digital-cyclic ratio converter (52) receiving the connections for the least significant byte n, a second rectangular voltage signal with cycle T', the cyclic ratio of which, with identical amplitude characteristics to those of the first signal, amounts to n/256,
   - filtering (53) said second rectangular signal in order to extract its mean value $Vx=Vr \cdot n/256$ from it,

   - applying said first rectangular signal to the first input (55) of an analog commutator (54), and a continuous voltage Vx to the second input (56) of said commutator, said commutator being alternately passed between one or the other of its inputs and its output,
   - applying a control signal with cycle T' to said analog commutator, such that said analog commutator: is passed between its second input and its output during a time period of $t'=T'/256$ during the passage of said first signal, from its high plateau towards its low plateau, and is passed between its first input and its output during the supplementary cycle (T' - t') to cycle T', as a result of which a variable voltage as a function of time Vs(t) appears at the output of said commutator, and then finally
   - filtering (58) the voltage Vs(t) in order to extract its mean value from it

$$Vm = Vr(256N+n)/65536$$

   which constitutes the analog output.

6. Device for carrying out the method of measuring the ratio of two impedances Z1, Z2 of the same nature contained in a measurement cell connected to a measurement device according to Claim 1, characterised by:

   - a clock (2) for generating rectangular signals Vh with substantially constant cycle (T),
   - a commutation assembly (1c) comprising two electronic commutators (4, 6) each provided with two inputs and one output, each of the two inputs of each commutator (4, 6) being capable of connection to the corresponding output of the commutator (4, 6) under the pulse of the clock voltage Vh, one input, referred to as the first of the first commutator (4) being connected to a source of voltage Vr, one input, referred to as the first of the second commutator (6), being connected to a source (earth) of zero voltage (V0), the inputs, referred to as the second inputs of said commutators, being interconnected to receive a voltage Vm, while the input of the first commutator (4) is connected to the input of impedance Z1, and the output of the second commutator (6) is connected to the input of impedance Z2, the outputs of the impedances Z1 and Z2 being connected to an output line (7), as a result of which, when the clock voltage passes from the value Vh to the value 0, and vice versa, the outputs of the commutators firstly pass from the value Vr to value Vm and vice versa, and secondly from value 0 to value Vm, thus assuring the generation of voltages V1(t) and V2(t),

- an operational amplifier (12) mounted as a looped adder on an impedance of the same nature as Z1 and Z2, and receiving the signal of said output impedance line (7) at its inverter input (10),

  as a result of which the output (14) of the operational amplifier (12) is brought to a periodic voltage V(t), with cycle T equal to that of the clock (2), discontinuous on two thresholds, the difference E of which, said error signal, is only dependent on Vr and Vm and is proportional to $(Vr \cdot Z1/(Z1+Z2))Vm$,

- a synchronous detector (18) controlled by the clock (2) and receiving at its input (16) the signal emitted by the operational amplifier (12) in order to extract the signal E.

7. Device according to Claim 6, characterised in that where the impedances Z1 and Z2 subjected to measurement are capacitances C1 and C2 and the measurement cell is arranged remote from the measurement device comprising said commutation assembly and the operational amplifier (12), the lines connecting said capacitances to the outputs of electronic commutators (4, 6) on the one hand and to the inverter input of said operational amplifier (12) on the other hand (lines 3, 3', 5, 5' and 7, 7' respectively) are coaxial lines, the casings (3', 5' and 7') of which are connected to earth.

8. Device according to Claim 6, characterised in that where the impedances Z1 and Z2 subjected to measurement are capacitances C1 and C2 and the measurement cell is arranged remote from the measurement device comprising said commutation assembly and the operational amplifier (12), the lines connecting said capacitances to the outputs of electronic commutators (4, 6) on the one hand and to the inverter input of said operational amplifier (12) on the other hand (lines 3, 3', 5, 5' and 7, 7' respectively) are coaxial lines, the casings (3', 5') of the lines connecting said capacitances to said commutators are connected to earth, while the casing of the line (7) connecting said capacitances to said operational amplifier is connected to the inverter input and the output of a second operational amplifier (13) mounted as a tracker amplifier to achieve an active guard.

9. Device according to Claims 6, 7 or 8, characterised by

- an oscillator (36), the frequency of which is controlled by the signal emitted from the synchronous detector (18), and proportionally to said signal,

- a binary forward-backward counter (40) with parallel outputs (42) receiving the signal emitted from said oscillator (36) and providing the binary word M of sixteen bits, and

- a digital-analog converter for converting said binary word M to its analog representation, said digital-analog converter comprising:

  two low-pass filters (53, 58), referred to respectively as the first and second, the converters (51 and 52) each being essentially composed of a binary forward-backward counter, the first converter (51) receiving the connections of the heavy weight octet representing N, and the second converter (52) receiving the connections of the low weight octet representing n, said binary word of sixteen bits having the value M=256N+n, each of the converters receiving a reference voltage Vr defining the amplitude of its rectangular output signal in relation to the earth Vo, whereby the output of the first converter (51) is connected to the first input (55) of the commutator (54), and the output of the second converter is connected to the second input (56) of the commutator across said second low-pass filter (58), the output (57) of the commutator itself being connected to the input of the first low-pass filter (53), whereby the commutator (54) is controlled by the time base (59) in order to be passed between its second input (56) and its output (57) during a cycle $t' = T'/256$ commencing at the descending flank of the first converter, and to be passed between its first input (55) and its output during the supplementary cycle (T'-t') of cycle T', as a result of which the signal Vs(t) is averaged at the output of the first filter (53) to a value Vm equal to $Vr \cdot (256N+n)/65536$.

10. Device according to Claim 9, most particularly intended for the measurement of ratios of the capacitances C1, C2, Cref of a measurement cell, characterised in that it comprises:

- an assembly (61) of three commutators, and

- a commutation matrix (62) intended to apply a selection of signals Vm, Vr, Vo and Vt to the inputs of said three commutators, signal Vt being a measurement of temperature supplied by a temperature sensor (94),

as a result of which the following ratios of the capacitances may be calculated:
C1/(C1+C2), C2/(C1+C2), Cref/(Cref+C1), Cref/(Cref+C2) as well as the magnitude $Nt = 65536 \cdot Vt/Vr$.

fig.1

fig.2

fig.3

fig.4

fig.5

fig.6

Fig.7